# EUROPÄISCHE PATENTSCHRIFT

(11) **EP 0 740 347 B1**
(45) Veröffentlichungstag und Bekanntmachung des Hinweises auf die Patenterteilung: **28.08.2002**
(21) Anmeldenummer: 95106098.7
(22) Anmeldetag: 24.04.1995
(51) Int. Cl.: H01L 27/115, H01L 27/108, H01L 21/8239

(54) **Halbleiter-Speichervorrichtung unter Verwendung eines ferroelektrischen Dielektrikums und Verfahren zur Herstellung**
Semiconductor memory structure, using a ferroelectric dielectric and method of formation
Structure de mémoire à semi-conducteurs utilisant un diélectrique ferroélectrique et méthode de fabrication

(43) Veröffentlichungstag der Anmeldung: 30.10.1996
(73) Patentinhaber: Infineon Technologies AG, 81669 München (DE)
(72) Erfinder: Tempel, Georg, Dr. rer. nat., D-81927 München (DE)
(74) Vertreter: Müller - Hoffmann & Partner

(56) Entgegenhaltungen:
- EP-A- 0 503 078
- EP-A- 0 557 590
- DE-A- 3 922 456
- DE-A- 4 107 165
- MICROELECTRONIC ENGINEERING, Bd. 22, Nr. 1 / 04, 1.August 1993 Seiten 53-60, XP 000385135 LARSEN P K ET AL 'FERROELECTRICS AND HIGH PERMITTIVITY DIELECTRICS FOR MEMORY APPLICATIONS'
- 1994 SYMPOSIUM ON VLSI TECHNOLOGY, DIGEST OF TECHNICAL PAPERS, 7.Juni 1994 - 9.Juni 1994 HONOLULU, Seiten 55-56, R. MOAZZAMI ET AL. 'Integration of ferroelectric capacitor technology with CMOS'
- IEICE TRANSACTIONS ON ELECTRONICS, Bd. E75-C, Nr. 11, 1.November 1992 Seiten 1313-1321, XP 000336333 KAZUHIKO SAGARA ET AL 'RECESSED MEMORY ARRAY TECHNOLOGY FOR A DOUBLE CYLINDRICAL STACKED CAPACITOR CELL OF 256M DRAM'

## Beschreibung

Die Erfindung bezieht sich auf eine Halbleiter-Speichervorrichtung mit einer Vielzahl von auf einem Halbleitersubstrat angeordneten Speicherzellen, von denen jede einen in einer zur Oberfläche des Halbleitersubstrates im wesentlichen parallel verlaufenden Ebene angeordneten und jeweils einen Gateanschluß sowie einen ersten und einen zweiten Elektrodenanschluß aufweisenden Auswahltransistor und einen dem Auswahltransistor zugeordneten und vermittels diesem ansteuerbaren Speicherkondensator mit einem ferroelektrischen Dielektrikum sowie einer ersten und einer zweiten Kondensatorelektrode aufweist, wobei jeder Gateanschluß des Auswahltransistors mit einer Wortleitung der Halbleiter-Speichervorrichtung, jeder erste Elektrodenanschluß des Auswahltransistors mit einer Bitleitung, und jede erste Kondensatorelektrode des Speicherkondensators mit einer gemeinsamen Leiterschicht aus elektrisch leitendem Material verbunden ist, sowie auf ein Verfahren zur Herstellung einer solchen Halbleiter-Speichervorrichtung.

Eine derartige Halbleiter-Speichervorrichtung mit einem Speicherkondensator mit einem ferroelektrischen Dielektrikum (sogenannter FRAM) ist beispielsweise aus R. Moazzami et al, Symposium on VLSI Technology Digest of Technical Papers 1994, Seiten 55 ff., und Tatsumi Sumi et al., IEEE International Solid-State Circuits Conference 1994, Seiten 268 ff. bekannt, bei welcher Halbleiter-Speichervorrichtung die Speicherkondensatoren mit dem ferroelektrischen Dielektrikum planar ausgebildet sind und auch aufgrund der Verdrahtung erhebliche Zellflächen pro Bit aufweisen, was angesichts einer erwünschten hohen Integrationsdichte als nachteilig angesehen wird. Trotz der bislang noch bestehenden Probleme wird den ferroelektrischen Speichern bzw. FRAMs eine große Zukunft vorausgesagt. Sie könnten die gegenwärtigen Halbleiter-Speicher (DRAM, SRAM, EEPROM, Flash EEPROM) vollständig verdrängen. Die Vorteile von FRAMs liegen vor allem in der kurzen Programmierzeit (> 20 ns), in einer niedrigen Programmierspannung (ab etwa 3 V Speisespannung der ICs), einem niedrigen Energieverbrauch beim Programmieren (keine Ladungspumpe erforderlich), sowie einer häufigen Programmierbarkeit (10¹² nachgewiesen, 10¹⁵ erwartet, gegenüber 10⁵ bei EEPROMs). Insbesondere zum heutigen Zeitpunkt aussichtsreich erscheinende Materialen für die ferroelektrische Schicht sind beispielsweise Blei-Zirkonium-Titanat, Strontium-Tantalat oder Verbindungen hiervon. Eines der Probleme, die einer raschen Einführung der FRAM-Technologie noch im Wege stehen, ist die noch nicht gelöste Kompatibilität mit einem Herstellprozeß für Integrierte Schaltungen. Insbesondere die Notwendigkeit von Platin-Elektroden an der ferroelektrischen Speicherkapazität und der bis zum jetzigen Zeitpunkt üblichen Schleudertechnik für das Aufbringen des ferroelektrischen Gels, die verbunden ist mit einer relativ großen Schichtdicke und damit flächenintensiven Kapazität, verhinderten bis heute einen vertretbaren Einsatz in der Halbleitertechnologie, so daß bislang kein serientauglicher Prozeß für die Herstellung von FRAMs bekannt ist. Hierbei ist auch zu berücksichtigen, daß die Abscheidung der relativ komplexen Materialen für das ferroelektrische Dielektrikum und damit verbunden das Problem einer zufriedenstellenden und prozeßtauglichen Quelle, darüber hinaus eine mangelnde Qualität der Schichten aufgrund von Rißbildung, Leckströmen, Temperatureinflüssen sowie Elektrodenhaftung zu den Problemen einer Prozeß-Integration beiträgt. Hierbei reagieren insbesondere die bisher bekannten ferroelektrischen Materialien äußerst empfindlich auf Wasserstoff, welcher sich aber kaum in den bekannten Verfahren zur Herstellung einer Halbleiter-Speichervorrichtung unterdrücken läßt, und dort insbesondere bei Plasmaabscheidungsprozessen und Plasmaätzprozessen vorkommt.

Neben diesen FRAM-Zellen sind hochintegrierte DRAM-Halbleiterspeicher mit herkömmlichen Materialien für das Dielektrikum des Speicherkondensators bekannt. Hierbei werden zur Realisierung von DRAM-Halbleiterspeicher mit einer Speicherkapazität von derzeit bis etwa 256 Megabit Dielektrika mit einer hohen dielektrischen Konstante eingesetzt, um bei geringer werdender Zellfläche trotzdem eine ausreichende Kapazität, typischerweise von mehr als etwa 20 fF pro Zelle zu erreichen. Für diese Zwecke wird bis heute in den meisten Fällen eine ONO-Schicht eingesetzt, bei der mittlerweile die technologischen Grenzen erkennbar sind, da der Leckstrom über den vorgegebenen Grenzwert bei einer weiteren Reduktion der Dicke ansteigt, und ausreichende Kapazitäten (Flächen) nur noch mittels aufwendiger Strukturen wie Trench- oder Stacked-Kondensatoren erhalten werden können. Aus diesen Gründen werden in zunehmenden Maße für das Dielektrikum des Speicherkondensators neue Materialien mit ausreichend hoher dielektrischen Konstante eingesetzt; allerdings sind die bislang bekannten alternativen dielektrischen Materialien äußerst empfindlich auf die im bisher verwendeten Verfahren zur Herstellung einer Halbleiter-Speichervorrichtung auftretenden üblichen Belastungen, namentlich Stabilität gegen hohe Prozeßtemperaturen, unerwünschte chemische Reaktionen und dergleichen.

Aus der EP-A-0 503 078 ist eine FRAM-Halbleiterspeicherzelle mit einem planar ausgebildeten Speicherkondensator mit ferroelektrischem Dielektrikum, unterer Kondensatorelektrode sowie oberer Kondensatorelektrode bekannt.

Aus der DE-A-3 922 456 ist eine herkömmliche DRAM-Halbleiterspeichereinrichtung mit einer geschichteten Kondensatorzelle bekannt.

Aus IEICE Trans. Electron., Bd. E75-C, Nr. 11 (1992), S. 1313 - 1321, ist eine 256-M-DRAM-Halbleiterspeichervorrichtung mit einer RSTC-Anordnung ("Recessed Stacked Capacitor") des Speicherkondensators bekannt

Ausgehend von diesem Stand der Technik liegt der Erfindung die Aufgabe zugrunde, eine Halbleiter-Speichervorrichtung mit einer ferroelektrischen Speicherkapazität, die eine zu den bisherigen DRAM-Schaltungen annähernd vergleichbare Integrationsdichte bei entsprechend hoher Zuverlässigkeit und Qualität besitzt, sowie ein Verfahren zur Herstellung einer solchen Halbleiter-Speichervorrichtung zur Verfügung zu stellen, welches mit vergleichsweise geringem Aufwand in bestehende Prozeßabläufe integriert werden kann, dabei serientauglich ist, d.h. eine hohe Ausbeute der gefertigten Halbleiter-Speichervorrichtungen mit ferroelektrischen Speicherkondensatoren bei geringstmöglicher Anzahl von Frühausfällen ermöglicht.

Diese Aufgabe wird erfindungsgemäß durch eine Halbleiter-Speichervorrichtung gemäß Anspruch 1 und durch ein Verfahren zur Herstellung einer Halbleiter-Speichervorrichtung gemäß Anspruch 13 gelöst.

Erfindungsgemäß ist eine Halbleiter-Speichervorrichtung der gattungsgemäßen Art vorgesehen, bei welcher der dem Auswahltransistor zugeordnete Speicherkondensator mit dem ferroelektrischen Dielektrikum eine gegenüber der Ebene der Substratoberfläche aufragende Anordnung besitzt. Hierbei ist der Speicherkondensator mit dem ferroelektrischen Dielektrikum innerhalb eines bis zu dem zweiten Elektrodenanschluß des Auswahltransistors reichenden Grabens angeordnet. Diese Ausbildung des Speicherkondensators mit dem ferroelektrischen Dielektrikum in einer aufragenden Anordnung ermöglicht es, bei kleinstmöglicher Fläche der FRAM-Zelle trotzdem eine ausreichende Kapazität zu erreichen, wobei die erfindungsgemäße Ausbildung mit einer gegenüber der Ebene der Substratoberfläche aufragenden Anordnung des ferroelektrischen Speicherkondensators die Ausbildung des hinsichtlich der gewünschten hohen Integrationsdichte kritischer anzusehenden Ferroelektrikum nach einer vollständigen Fertigung der diesbezüglich weniger kritischen Bestandteile der Speicherzelle, d.h. Auswahltransistor mit vollständiger Metallisierung einschließlich Elektroden, ermöglicht wird, vorzugsweise dadurch, daß das vermittels Schleudertechnik aufzubringende ferroelektrische Gel innerhalb einer zwischen den beiden Kondensatorelektroden gebildeten dünnen Hohlschicht eingebracht wird, wobei die Hohlschicht ebenfalls eine gegenüber der Ebene der Substratoberfläche aufragende Anordnung besitzt.

Dem Prinzip der Erfindung folgend ist vorgesehen, daß die gegenüber der Ebene der Substratoberfläche aufragende Anordnung des Speicherkondensators im wesentlichen zylindersymmetrisch ausgebildet ist mit einer wenigstens annähernd senkrecht zur Ebene der Substratoberfläche verlaufenden Zylindermittenachse.

Die zweite Kondensatorelektrode des innerhalb des Grabens ausgebildeten Speicherkondensators kann eine entsprechend der Innenkontur des Grabens becherförmig ausgebildete Form mit einem quer zur Längserstreckung des Speicherkondensators annähernd U- bzw. V-förmig ausgebildeten Querschnitt besitzen, wobei der Bodenbereich der im Querschnitt annähernd U- bzw. V-förmig ausgebildeten zweiten Kondensatorelektrode elektrisch mit dem zweiten Elektrodenanschluß des Auswahltransistors gekoppelt ist.

Bei einer weiterhin bevorzugten Ausgestaltung ist vorgesehen, daß die erste Kondensatorelektrode des Speicherkondensators einen innerhalb des Grabens ausgebildeten, koaxial zur Längserstreckung des Grabens und gegenüberliegend zur zweiten Kondensatorelektrode verlaufenden Elektrodenabschnitt aufweist, und das ferroelektrische Dielektrikum zumindest zwischen dem Elektrodenabschnitt der ersten Kondensatorelektrode und der zweiten Kondensatorelektrode angeordnet ist. Dabei kann die erste Kondensatorelektrode des Speicherkondensators becherförmig innerhalb der zweiten Kondensatorelektrode ausgebildet sein.

Bei einer weiteren vorteilhaften Ausbildung kann vorgesehen sein, daß zwischen dem Bodenbereich der zweiten Kondensatorelektrode und einem Bodenabschnitt des innerhalb der zweiten Kondensatorelektrode becherförmig ausgebildeten ersten Kondensatorelektrode eine Zwischenschicht aus einem elektrisch isolierenden Material vorgesehen ist, wobei die aus einem elektrisch isolierenden Material hergestellte Zwischenschicht eine Bufferschicht für eine naßchemische Ätzung aufweisen kann.

Das erfindungsgemäße Verfahren sieht vor, den dem Auswahltransistor zugeordneten Speicherkondensator mit dem ferroelektrischen Dielektrikum nach Fertigstellung des Auswahltransistors und seiner zugehörigen Metallisierungsschichten für den Anschluß der Wort- und Bitleitungen in einer gegenüber der Ebene des zur Oberfläche des Halbleitersubstrates im wesentlichen parallel angeordneten Auswahltransistors aufragenden Anordnung herzustellen. Hierbei wird der Speicherkondensator mit dem ferroelektrischen Dielektrikum innerhalb eines bis zu dem zweiten Elektrodenanschluß des Auswahltransistors reichenden Grabens angeordnet.

Dem Konzept des erfindungsgemäßen Verfahrens liegt hierbei zunächst die Erkenntnis zugrunde, eine Halbleiter-Speichervorrichtung bzw. einen Prozeßablauf zur Herstellung der Halbleiter-Speichervorrichtung anzugeben, bei dem die ferroelektrischen Materialien in den Prozeßablauf zur Herstellung der Halbleiter-Speichervorrichtung mit Erfolg eingebunden werden können, und zwar dadurch, daß erst nach der Fertigung der vollständig ausgebildeten Auswahltransistoren samt vollständiger Metallisierung einschließlich aller dem Auswahltransistor zugeordneten Elektroden das dielektrische Material aufgebracht und zur Durchführung der notwendigen Kristallisation einer Wärmebehandlung unterzogen wird, wobei die vor dieser Wärmebehandlung aufgebrachten Leiterbahnen aus einem temperaturstabilen Material wie beispielsweise Wolfram oder Kupfer gefertigt sein können.

Dem Prinzip der Erfindung folgend sieht das Verfahren zur Herstellung einer Halbleiter-Speichervorrichtung mit einem Speicherkondensator mit einem ferroelektrischen Dielektrikum nach Fertigstellung des Auswahltransistors folgende Schritte vor:
Ätzen eines zumindest bis zu dem zweiten Elektrodenanschluß des Auswahltransistors reichenden Grabens,
zur Innenkontur des Grabens konformes Abscheiden einer elektrisch leitenden Schicht für die zweite Kondensatorelektrode innerhalb des Grabens,
konformes Abscheiden einer als Platzhalter für das ferroelektrische Dielektrikum dienenden Hilfsschicht innerhalb des Grabens auf die elektrisch leitende Schicht für die zweite Kondensatorelektrode,
konformes Abscheiden der elektrisch leitenden Schicht für die erste Kondensatorelektrode innerhalb des Grabens auf die Hilfsschicht,
Entfernen der Hilfsschicht und dadurch Freilegen einer Hohlschicht zwischen den beiden elektrisch leitenden Schichten für die erste und die zweite Kondensatorelektrode,
Abscheiden des ferroelektrischen Dielektrikums in die freigelegte Hohlschicht zwischen den beiden elektrisch leitenden Schichten für die erste und die zweite Kondensatorelektrode,

In bevorzugter Weise wird der Schritt des Abscheidens der das ferroelektrische Dielektrikum aufweisenden dielektrischen Schicht vermittels Aufschleudern durchgeführt.

Bei einem insbesondere bevorzugten Prozeßablauf zeichnet sich das erfindungsgemäße Verfahren durch die folgenden weiteren Verfahrensschritte aus:
Rückätzen der zur Innenkontur des Grabens konform abgeschiedenen elektrisch leitenden Schicht für die zweite Kondensatorelektrode zumindest soweit, daß ein Teil des oberen Randbereiches innerhalb des Grabens und der außerhalb des Grabens planar abgeschiedene Teil der elektrisch leitenden Schicht für die zweite Kondensatorelektrode entfernt wird.Auf diese Weise wird die Gefahr eines elektrischen Kurzschlusses der beiden Kondensatorelektroden vermindert.

Des weiteren wird die Halbleiter-Speichervorrichtung durch ein ganzflächiges Abscheiden einer elektrisch leitenden Schicht für die gemeinsame Leiterschicht auf die elektrisch leitende Schicht für die erste Kondensatorelektrode, und ein ganzflächiges Abscheiden einer Passivierungsschicht auf die gemeinsame Leiterschicht vervollständigt.

In weiterer Einzelausgestaltung des Verfahrens zur Herstellung einer Halbleiter-Speichervorrichtung kann vorgesehen sein, daß vor dem Schritt des konformen Abscheidens der als Platzhalter für das ferroelektrische Dielektrikum dienenden Hilfsschicht der Graben mit einer Zwischenschicht aus einem elektrisch isolierenden Material wenigstens teilweise befüllt wird, wobei die aus einem elektrisch isolierenden Material hergestellte Zwischenschicht eine Bufferschicht für eine naßchemische Ätzung aufweist und dem Schritt des wenigstens teilweisen Befüllens des Grabens mit der Zwischenschicht eine Rückätzung derselben nachgeschaltet sein kann.

Bei einer insbesondere bevorzugten Ausgestaltung der Halbleiter-Speichervorrichtung bzw. dem Verfahren gemäß der Erfindung stellt das ferroelektrische Dielektrikum ein ferroelektrisches Gel dar, welches insbesondere eine Blei-Zirkonium-Titanat- (PZT) und/oder eine Strontium-Tantalat-Verbindung (Y-1) aufweist.

Des weiteren weist das Material der Schicht für die erste und/oder zweite Kondensatorelektrode vorzugsweise Titan und/oder Platin auf, wobei die Schicht für die erste und/oder zweite Kondensatorelektrode auch als Mehrfachschicht ausgebildet sein kann, und zwar vorzugsweise mit einer Schichtenfolge Titan/-Titannitrid/Platin.

Die zwischen dem Bodenbereich der zweiten Kondensatorelektrode und dem Bodenabschnitt des innerhalb der zweiten Kondensatorelektrode becherförmig ausgebildeten ersten Kondensatorelektrode vorgesehene Zwischenschicht kann in vorteilhafter Weise aus einem Flow-Glas-Material hergestellt sein. Die als Platzhalter für das ferroelektrische Dielektrikum dienende Hilfsschicht stellt beispielsweise ein CVD-Oxid dar. Ferner stellt das Füllmaterial zum Auffüllen des im Graben verbleibenden Hohlraumes ein hochtemperaturstabiles Material darstellt, welches insbesondere Wolfram oder eine Wolframverbindung aufweist.

Die Erfindung ist in der nachfolgenden Beschreibung anhand eines in der Zeichnung dargestellten Ausführungsbeispieles im einzelnen beschrieben.

In der Zeichnung zeigt
Figur 1 ein Prinzipschaltbild einer erfindungsgemäßen Halbleitervorrichtung mit einer FRAM-Zelle,
Figur 2 bis Figur. 6 aufeinanderfolgende Verfahrensschritte der Herstellung der erfindungsgemäßen Halbleiter-Speichervorrichtung.

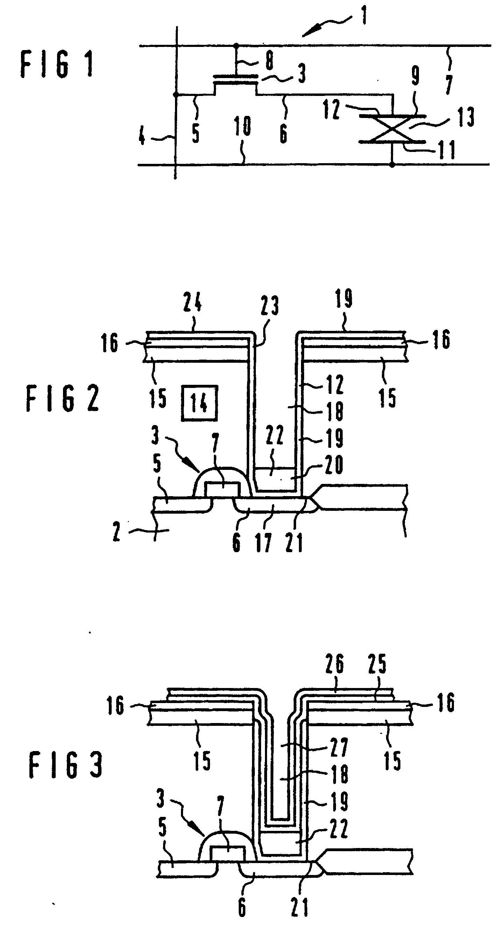

Eine erfindungsgemäße Halbleiter-Speichervorrichtung mit einer FRAM-Zelle 1 gemäß dem Ersatzschaltbild nach Fig. 1 besitzt einen auf einem Halbleiter-Substrat 2 ausgebildeten Auswahltransistor 3 vorzugsweise vom MOS-Typ mit einem an eine aus Wolfram oder Polyzid hergestellte Bitleitung 4 angeschlossenen ersten Elektrodenanschluß 5 (Source), einem zweiten Elektrodenanschluß 6 (Drain) und einen an eine aus n⁺-Poly-Si oder Polyzid hergestellte Wortleitung 7 angeschlossenen Gateanschluß 8, sowie einen Speicherkondensator 9 mit einer mit einer gemeinsamen Leiterschicht 10 (Feldplatte) verbundenen ersten Kondensatorelektrode 11, mit dem zweiten Elektrodenanschluß 6 des Auswahltransistors 3 verbundenen zweiten Kondensatorelektrode 12 und einem zwischen die erste und zweite Kondensatorelektrode eingebrachten ferroelektrischen Dielektrikum 13.

Ausgangspunkt des in den Fig. 2 bis 6 dargestellten Ausführungsbeispieles des erfindungsgemäßen Verfahrens zur Herstellung der Halbleiter-Speichervorrichtung ist die in Fig. 2 vermittels an sich bekannter Verfahrensschritte bis zur vollständigen Fertigung der Auswahltransistoren, Wortleitungen, Bitleitungen, Peripherietransistoren, Metallisierung sowie Passivierung aufweisende Anordnung, wobei neben den bereits bezeichneten Bestandteilen die Bezugsziffer 14 die lediglich schematisch angedeuteten Metallisierungslagen für den Anschluß der Wort- und Bitleitungen bezeichnet.

Als Deckschicht auf die vermittels herkömmlicher DRAM-Prozeßabläufe hergestellte Anordnung gemäß Fig. 2 wird zunächst ganzflächig eine isolierende Nitrid-Schicht 15 mit einer Dicke von vorzugsweise etwa 100 nm bis 500 nm aufgebracht und vermittels eines an sich bekannten Fotolithographieschrittes bzw. unter Verwendung einer zusätzlichen Maskierschicht 16, welche beispielsweise aus Poly-Si hergestellt und als relativ harte Maskierschicht für eine nachfolgende Ätzung dient, strukturiert. Daran anschließend wird durch alle Oxidschichten hindurch bis zum n⁺-dotierten Diffusionsgebiet 17 des zweiten Elektrodenanschlusses 6 des Auswahltransistors 3 ein gegenüber der Ebene 21 der Substratoberfläche aufragend ausgebildeter Graben 18 vermittels eines Kontaktlochätzschrittes geätzt, wobei die Ätzung wenigstens zum Teil überlappend ausgeführt sein kann. Daran anschließend wird für die Herstellung des Anschlusses an das Diffusionsgebiet 17 des Auswahltransistors 3 konform eine leitende Schicht 19 für die zweite Kondensatorelektrode 12 abgeschieden. Die leitende Schicht 19 kann gegebenenfalls als Mehrfachschicht mit der Schichtenfolge Ti/TiN/Pt ausgebildet sein (mit Ti als der dem n⁺-Si zugewandten Schicht) und gegebenenfalls eine (nicht näher dargestellte) zusätzliche Bufferschicht besitzen. Der verbliebene Hohlraum des Grabens 18 wird mit einem geeigneten Flow-Glasmaterial 20 aufgefüllt, welches anschließend vorzugsweise naßchemisch zurückgeätzt wird, um am Boden des Grabens 18 eine ausreichende Bufferschicht 22 für die nachfolgende Ätzung zu erhalten. Zur Verhinderung eines elektrischen Kurzschlusses zur später vervollständigten gemeinsamen Leiterschicht 10 für die Feldplatte wird die leitende Schicht 19 wenigstens soweit zurückgeätzt, daß ein Teil 23 des oberen Randbereiches der elektrisch leitenden Schicht 19 innerhalb des Grabens 18 und der außerhalb des Grabens 18 planar abgeschiedene Teil 24 der elektrisch leitenden Schicht 19 entfernt wird.

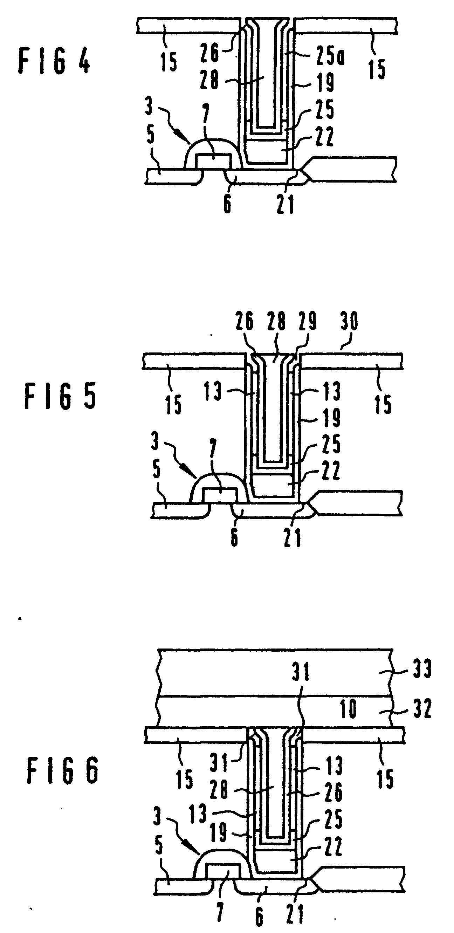

Auf die somit entstehende Anordnung wird gemäß Fig. 3 eine als Platzhalter für das ferroelektrische Dielektrikum dienende Hilfsschicht 25 aus einem CVD-Oxid innerhalb des Grabens 18 auf die elektrisch leitende Schicht 19 konform abgeschieden. Daran anschließend wird eine elektrisch leitende Schicht 26 für die erste Kondensatorelektrode 11 innerhalb des Grabens 18 auf die Hilfsschicht 25 konform abgeschieden. Die elektrisch leitende Schicht 26 kann vorzugsweise aus Platin oder einem anderen geeigneten Metall hergestellt sein, und darüberhinaus auch als Mehrfachschicht ausgebildet sein, vorzugsweise mit der Schichtenfolge Pt/TiN/Ti. Der im Graben 18 verbleibende Hohlraum 27 wird gemäß Fig. 4 mit einem hochtemperaturstabilen Füllmaterial 28, welches vorzugsweise Wolfram aufweist, gefüllt. Nach der Auffüllung mit Wolfram wird das Füllmaterial 28 und die gegebenenfalls vorhandene Maskierschicht 16 zurückgeätzt bzw. zurückgeschliffen.

Nach Durchführung einer Wärmebehandlung vermittels Formiergas-Temperung und dadurch Ausheilen aller vorherigen Prozeßschritte wird das als Platzhalter für das ferroelektrische Dielektrikum dienende Material der Hilfsschicht 25 naßchemisch freigeätzt, wie es in Fig. 4 dargestellt ist, und zwar wenigstens so weit, daß zwischen den beiden Schichten 19 und 26 für die Kondensatorelektroden 11 und 12 eine gegenüber der Ebene 21 der Substratoberfläche im wesentlichen annähernd senkrecht ausgerichtete Hohlschicht 25a gebildet wird, in welche daran anschließend das Material für das ferroelektrische Dielektrikum 13 vermittels Schleuderverfahren (Spin-On-Technik) eingebracht bzw. abgeschieden und zur Kristallbildung einem Wärmebehandlungsschritt unterzogen.wird. Ein bei der naßchemischen Ätzung des CVD-Oxids 25 stehengelassener Boden dient zur mechanischen Abstützung der koaxial innerhalb des Grabens angeordneten ersten Kondensatorelektrode 26.

Daran anschließend kann das dielektrische Material 13 zumindest so weit zurückgeätzt werden, daß ein Teil 29 des oberen Randbereiches des ferroelektrischen Dielektrikums innerhalb des Grabens 18 und der außerhalb des Grabens planar abgeschiedene Teil 30 des ferroelektrischen Dielektrikums 13 entfernt wird. Auf diese Weise ergibt sich die in Fig. 5 dargestellte Anordnung.

Daran anschließend wird eine isolierende Schicht 31 abgeschieden, die zur elektrischen Isolierung der sich hieran anschließenden Feldplatte 10 dient. Zur Ausbildung einer planaren Oberfläche wird die abgeschiedene isolierende Schicht 31 zurückgeätzt bzw. zurückgeschliffen. Nach diesem Schritt wird die als Feldplatte 10 für den gemeinsamen Anschluß der ersten Kondensatorelektroden 11 dienende elektrisch leitende Schicht 32 abgeschieden und gegebenenfalls strukturiert. Hieran schließt sich zur Vervollständigung ein Schritt der Abscheidung einer Passivierungsschicht 33 an.

## Patentansprüche

1. Halbleiter-Speichervorrichtung mit einer Vielzahl von auf einem Halbleitersubstrat angeordneten Speicherzellen (1), von denen jede einen in einer zur Oberfläche eines Halbleitersubstrates im wesentlichen parallel verlaufenden Ebene (21) angeordneten und jeweils einen Gateanschluss (8) sowie einen ersten (5) und einen zweiten Elektrodenanschluss (6) aufweisenden Auswahltransistor (3) und einen dem Auswahltransistor (3) zugeordneten und vermittels diesem ansteuerbaren Speicherkondensator (9) mit einem Dielektrikum (13) sowie einer ersten (11) und einer zweiten Kondensatorelektrode (12) aufweist, wobei jeder Gateanschluss (8) des Auswahltransistors (3) mit einer Wortleitung (7) der Halbleiter-Speichervorrichtung, jeder erste Elektrodenanschluss (5) des Auswahltransistors (3) mit einer Bitleitung (4), und jede erste Kondensatorelektrode (11) des Speicherkondensators (9) mit einer gemeinsamen Leiterschicht (10) aus elektrisch leitendem Material verbunden ist, wobei der dem Auswahltransistor (3) zugeordnete Speicherkondensator (9) eine gegenüber der Ebene (21) der Substratoberfläche aufragende Anordnung besitzt, und die erste Kondensatorelektrode (11) des Speicherkondensators (9) innerhalb der zweiten Kondensatorelektrode (12) ausgebildet ist,
**dadurch gekennzeichnet, dass**
das Dielektrikum (13) des Speicherkondensators (9) ferroelektrisch ist, und dass zwischen einem Bodenbereich der zweiten Kondensatorelektrode (12) und einem Bodenabschnitt der ersten Kondensatorelektrode (11) anstelle des Dielektrikums (13) eine Zwischenschicht (20, 22, 25) aus einem anderen elektrisch isolierenden Material vorhanden ist.

2. Halbleiter-Speichervorrichtung nach Anspruch 1,
**dadurch gekennzeichnet, dass**
die gegenüber der Ebene (21) der Substratoberfläche aufragende Anordnung des Speicherkondensators (9) im wesentlichen zylindersymmetrisch ausgebildet ist mit einer wenigstens annähernd senkrecht zur Ebene (21) der Substratoberfläche verlaufenden Zylindermittenachse.

3. Halbleiter-Speichervorrichtung nach Anspruch 1 oder 2,
**dadurch gekennzeichnet, dass**
der Speicherkondensator (9) mit dem ferroelektrischen Dielektrikum (13) innerhalb eines bis zu dem zweiten Elektrodenanschluss (6) des Auswahltransistors (3) reichenden Grabens (18) angeordnet ist.

4. Halbleiter-Speichervorrichtung nach Anspruch 3,
**dadurch gekennzeichnet, dass**
die zweite Kondensatorelektrode (12) des innerhalb des Grabens (18) ausgebildeten Speicherkondensators (9) eine entsprechend der Innenkontur des Grabens (18) becherförmig ausgebildete Form mit einem quer zur Längserstreckung des Speicherkondensators (9) annähernd U- bzw. V-förmig ausgebildeten Querschnitt besitzt.

5. Halbleiter-Speichervorrichtung nach Anspruch 4,
**dadurch gekennzeichnet, dass**
der Bodenbereich der im Querschnitt annähernd U- bzw. V-förmig ausgebildeten zweiten Kondensatorelektrode (12) elektrisch mit dem zweiten Elektrodenanschluss (6) des Auswahltransistors (3) verbunden ist.

6. Halbleiter-Speichervorrichtung nach einem der Ansprüche 3 bis 5,
**dadurch gekennzeichnet, dass**
die erste Kondensatorelektrode (11) des Speicherkondensators (9) einen innerhalb des Grabens (18) ausgebildeten, koaxial zur Längserstreckung des Grabens (18) und gegenüberliegend zur zweiten Kondensatorelektrode (12) verlaufenden Elektrodenabschnitt aufweist, und das ferroelektrische Dielektrikum (13) zumindest zwischen dem Elektrodenabschnitt der ersten Kondensatorelektrode (12) und der zweiten Kondensatorelektrode angeordnet ist.

7. Halbleiter-Speichervorrichtung nach einem der Ansprüche 1 bis 6,
**dadurch gekennzeichnet, dass**
die erste Kondensatorelektrode (11) des Speicherkondensators (9) becherförmig innerhalb der zweiten Kondensatorelektrode (12) ausgebildet ist,

8. Halbleiter-Speichervorrichtung nach einem der Ansprüche 3 bis 7,
**dadurch gekennzeichnet, dass**
der Graben (18) vollständig innerhalb einer die Wortleitungen (7) sowie die Bitleitungen (4) der Halbleiter-Speichervorrichtung darstellenden Metallisierungsschicht bzw. Metallisierungsschichten gebildet und zur elektrischen Isolation gegenüber der Metallisierungsschicht bzw. Metallisierungsschichten mit einem elektrischen isolierenden Überzug versehen ist.

9. Halbleiter-Speichervorrichtung nach einem der vorherigen Ansprüche,
**dadurch gekennzeichnet, dass**
das ferroelektrische Dielektrikum (13) ein ferroelektrisches Gel darstellt, welches Blei-Zirkonium-Titanat- (PZT) oder eine Strontium-Tantalat-Verbindung (Y-1) enthält.

10. Halbleiter-Speichervorrichtung nach einem der vorherigen Ansprüche,
**dadurch gekennzeichnet, dass**
das Material der Schichten (19, 26) für die erste oder zweite Kondensatorelektrode (11, 12) oder für beide Kondensator-elektroden (11, 12) Titan oder Platin aufweist.

11. Halbleiter-Speichervorrichtung nach einem der vorherigen Ansprüche,
**dadurch gekennzeichnet, dass**
die Schichten (19, 26) für die erste oder zweite Kondensatorelektrode (11, 12) ) oder für beide Kondensatorelektroden (11, 12) als Mehrfachschicht ausgebildet sind.

12. Halbleiter-Speichervorrichtung nach Anspruch 11,
**dadurch gekennzeichnet, dass**
die Mehrfachschicht für die erste oder zweite Kondensatorelektrode (11, 12) oder für beide Kondensatorelektroden (11, 12) die Schichtenfolge Titan/Titannitrid/Platin aufweist.

13. Verfahren zur Herstellung einer Halbleiter-Speichervorrichtung mit einer Vielzahl von auf einem Halbleitersubstrat angeordneten Speicherzellen (1), von denen jede einen in einer zur Oberfläche des Halbleitersubstrates im Wesentlichen parallel verlaufenden Ebene (21) angeordneten und jeweils einen Gateanschluss (8) sowie einen ersten (5) und einen zweiten Elektrodenanschluss (6) aufweisenden Auswahltransistor (3) und einen dem Auswahltransistor (3) zugeordneten und vermittels diesem ansteuerbaren Speicherkondensator (9) mit einem ferroelektrischen Dielektrikum (13) sowie einer ersten (11) und einer zweiten Kondensatorelektrode (12) aufweist, wobei jeder Gateanschluss (8) des Auswahltransistors (3) mit einer Wortleitung (7) der Halbleiter-Speichervorrichtung, jeder erste Elektrodenanschluss (5) des Auswahltransistors (3) mit einer Bitleitung (4), und jede erste Kondensatorelektrode (11) des Speicherkondensators (9) mit einer gemeinsamen Leiterschicht (10) aus elektrisch leitendem Material verbunden ist, und wobei der dem Auswahltransistor (3) zugeordnete Speicherkondensator (9) mit dem ferroelektrischen Dielektrikum (13) nach Fertigstellung des Auswahltransistors (3) sowie seiner zugehörigen Metallisierungsschichten für den Anschluss der Wort- und Bitleitungen (4, 7) in einer gegenüber der Ebene (21) des zur Oberfläche des Halbleitersubstrates im wesentlichen parallel angeordneten Auswahltransistors (3) aufragenden Anordnung hergestellt wird,
**gekennzeichnet durch**
die folgenden Schritte nach Fertigstellung des Auswahltransistors (3) :
Ätzen eines zumindest bis zu dem zweiten Elektrodenanschluss (6) des Auswahltransistors (3) reichenden Grabens (18),
zur Innenkontur des Grabens (18) konformes Abscheiden einer elektrisch leitenden Schicht (19) für die zweite Kondensatorelektrode (12) innerhalb des Grabens (18),
konformes Abscheiden einer als Platzhalter für das ferroelektrische Dielektrikum (13) dienenden Hilfsschicht (25) innerhalb des Grabens (18) auf die elektrisch leitende Schicht (19) für die zweite Kondensatorelektrode (12),
konformes Abscheiden einer elektrisch leitenden Schicht (26) für die erste Kondensatorelektrode (11) innerhalb des Grabens (18) auf die Hilfsschicht (25),
teilweises Entfernen der Hilfsschicht (25) und **dadurch** Freilegen einer Hohlschicht (25a) zwischen den beiden elektrisch leitenden Schichten (19, 26) für die erste und die zweite Kondensatorelektrode,
Abscheiden des ferroelektrischen Dielektrikums (13) in die freigelegte Hohlschicht (25a) zwischen den beiden elektrisch leitenden Schichten (19, 26) für die erste und die zweite Kondensatorelektrode.

14. Verfahren zur Herstellung einer Halbleiter-Speichervorrichtung nach Anspruch 13,
**dadurch gekennzeichnet, dass**
der Schritt des Abscheidens der das ferroelektrische Dielektrikum (13) aufweisenden dielektrischen Schicht vermittels Aufschleudern durchgeführt wird.

15. Verfahren zur Herstellung einer Halbleiter-Speichervorrichtung nach Anspruch 13 oder 14,
**gekennzeichnet durch:**
Rückätzen der zur Innenkontur des Grabens (18) konform abgeschiedenen elektrisch leitenden Schicht (19) für die zweite Kondensatorelektrode (12) zumindest soweit, dass ein Teil (23) des oberen Randbereiches innerhalb des Grabens (18) und der außerhalb des Grabens planar abgeschiedene Teil (24) der elektrisch leitenden Schicht (19) für die zweite Kondensatorelektrode entfernt wird.

16. Verfahren zur Herstellung einer Halbleiter-Speichervorrichtung nach einem der Ansprüche 13 bis 15,
**gekennzeichnet durch**:
ganzflächiges Abscheiden einer elektrisch leitenden Schicht (32) für die gemeinsame Leiterschicht (10) auf die erste Kondensatorelektrode (11), und
ganzflächiges Abscheiden einer Passivierungsschicht (33) auf die gemeinsame Leiterschicht (10).

17. Verfahren zur Herstellung einer Halbleiter-Speichervorrichtung nach einem der Ansprüche 13 bis 16,
**dadurch gekennzeichnet, dass**
vor dem Schritt des konformen Abscheidens der als Platzhalter für das ferroelektrische Dielektrikum (13) dienenden Hilfsschicht (25) der Graben (18) mit einer Zwischenschicht (22) aus einem elektrisch isolierenden Material wenigstens teilweise befüllt wird.

18. Verfahren zur Herstellung einer Halbleiter-Speichervorrichtung nach Anspruch 17,
**dadurch gekennzeichnet, dass**
die aus einem elektrisch isolierenden Material (20) hergestellte Zwischenschicht (22) eine Bufferschicht für eine nasschemische Ätzung aufweist und dem Schritt des wenigstens teilweisen Befüllens des Grabens (18) mit der Zwischenschicht (22) eine Rückätzung der Bufferschicht nachgeschaltet wird.

19. Verfahren nach einem der Ansprüche 13 bis 18,
**dadurch gekennzeichnet, dass**
die Schichten (19, 26) für die erste oder zweite Kondensator-elektrode (11, 12) oder für beide Kondensatorelektroden (11, 12) als Mehrfachschicht ausgebildet werden.

20. Verfahren nach Anspruch 19,
**dadurch gekennzeichnet, dass**
die Mehrfachschicht für die erste oder zweite Kondensatorelektrode (11, 12) die Schichtenfolge Titan/Titannitrid/Platin aufweist.

21. Verfahren nach einem der Ansprüche 13 bis 20,
**dadurch gekennzeichnet, dass**
die zwischen dem Bodenbereich der zweiten Kondensatorelektrode (12) und dem Bodenabschnitt des innerhalb der zweiten Kondensatorelektrode (12) becherförmig ausgebildeten ersten Kondensatorelektrode (11) angeordnete Zwischenschicht (22) aus einem Flow-Glas-Material hergestellt wird.

22. Verfahren nach einem der Ansprüche 13 bis 21,
**dadurch gekennzeichnet, dass**
die als Platzhalter für das ferroelektrische Dielektrikum (13) dienende Hilfsschicht (25) ein CVD-Oxid darstellt.

## Claims

1. Semiconductor memory device having a multiplicity of memory cells (1) arranged on a semiconductor substrate, each of which memory cells has a selection transistor (3), which is arranged in a plane (21) running essentially parallel to the surface of a semiconductor substrate and in each case has a gate terminal (8) and also a first (5) and a second electrode terminal (6), and a storage capacitor (9), which is assigned to the selection transistor (3) and can be driven by means of the latter and has a dielectric (13) and also a first (11) and a second capacitor electrode (12), each gate terminal (8) of the selection transistor (3) being connected to a word line (7) of the semiconductor memory device, each first electrode terminal (5) of the selection transistor (3) being connected to a bit line (4) and each first capacitor electrode (11) of the storage capacitor (9) being connected to a common conductor layer (10) made of electrically conductive material, the storage capacitor (9) assigned to the selection transistor (3) having an arrangement projecting relative to the plane (21) of the substrate surface, and the first capacitor electrode (11) of the storage capacitor (9) being formed within the second capacitor electrode (12),
**characterized in that**
the dielectric (13) of the storage capacitor (9) is ferroelectric, and **in that**, instead of the dielectric (13), there is present between a bottom region of the second capacitor electrode (12) and a bottom section of the first capacitor electrode (11) an intermediate layer (20, 22, 25) made of a different electrically insulating material.

2. Semiconductor memory device according to Claim 1,
**characterized in that**
the arrangement of the storage capacitor (9) projecting relative to the plane (21) of the substrate surface is formed such that it is essentially cylinder-symmetrical, with a cylinder centre axis running at least approximately perpendicularly to the plane (21) of the substrate surface.

3. Semiconductor memory device according to Claim 1 or 2,
**characterized in that**
the storage capacitor (9) with the ferroelectric dielectric (13) is arranged within a trench (18) reaching as far as the second electrode terminal (6) of the selection transistor (3).

4. Semiconductor memory device according to Claim 3,
**characterized in that**
the second capacitor electrode (12) of the storage capacitor (9) formed within the trench (18) has a shape which is formed in a cup-shaped manner corresponding to the inner contour of the trench (18), with a cross section which is formed in an approximately U- or V-shaped manner transversely with respect to the longitudinal extent of the storage capacitor (9).

5. Semiconductor memory device according to Claim 4,
**characterized in that**
the bottom region of the second capacitor electrode (12) which is formed in an approximately U- or V-shaped manner in cross section is electrically connected to the second electrode terminal (6) of the selection transistor (3).

6. Semiconductor memory device according to one of Claims 3 to 5,
**characterized in that**
the first capacitor electrode (11) of the storage capacitor (9) has an electrode section which is formed within the trench (18) and runs coaxially with respect to the longitudinal extent of the trench (18) and opposite to the second capacitor electrode (12), and the ferroelectric dielectric (13) is arranged at least between the electrode section of the first capacitor electrode (12) and the second capacitor electrode.

7. Semiconductor memory device according to one of Claims 1 to 6,
**characterized in that**
the first capacitor electrode (11) of the storage capacitor (9) is formed in a cup-shaped manner within the second capacitor electrode (12), [sic]

8. Semiconductor memory device according to one of Claims 3 to 7,
**characterized in that**
the trench (18) is formed completely within a metallization layer or metallization layers constituting the word lines (7) and also the bit lines (4) of the semiconductor memory device and is provided with an electrically insulating coating for electrical insulation from the metallization layer or metallization layers.

9. Semiconductor memory device according to one of the preceding claims,
**characterized in that**
the ferroelectric dielectric (13) constitutes a ferroelectric gel which contains lead zirconium titanate (PZT) or a strontium tantalate compound (Y-1).

10. Semiconductor memory device according to one of the preceding claims,
**characterized in that**
the material of the layers (19, 26) for the first or second capacitor electrode (11, 12) or for both capacitor electrodes (11, 12) has titanium or platinum.

11. Semiconductor memory device according to one of the preceding claims,
**characterized in that**
the layers (19, 26) for the first or second capacitor electrode (11, 12) or for both capacitor electrodes (11, 12) are formed as a multilayer.

12. Semiconductor memory device according to Claim 11,
**characterized in that**
the multilayer for the first or second capacitor electrode (11, 12) or for both capacitor electrodes (11, 12) has the layer sequence titanium/titanium nitride/platinum.

13. Method for fabricating a semiconductor memory device having a multiplicity of memory cells (1) arranged on a semiconductor substrate, each of which memory cells has a selection transistor (3), which is arranged in a plane (21) running essentially parallel to the surface of the semiconductor substrate and in each case has a gate terminal (8) and also a first (5) and a second electrode terminal (6), and a storage capacitor (9), which is assigned to the selection transistor (3) and can be driven by means of the latter and has a ferroelectric dielectric (13) and also a first (11) and a second capacitor electrode (12), each gate terminal (8) of the selection transistor (3) being connected to a word line (7) of the semiconductor memory device, each first electrode terminal (5) of the selection transistor (3) being connected to a bit line (4) and each first capacitor electrode (11) of the storage capacitor (9) being connected to a common conductor layer (10) made of electrically conductive material, the storage capacitor (9) assigned to the selection transistor (3), with the ferroelectric dielectric (13) after the completion of the selection transistor (3) and its associated metallization layers for the connection of the word and bit lines (4, 7), being fabricated in an arrangement projecting relative to the plane (21) of the selection transistor (3) arranged essentially parallel to the surface of the semiconductor substrate,
**characterized by**
the following steps after the completion of the selection transistor (3) :
etching a trench (18) which reaches at least as far as the second electrode terminal (6) of the selection transistor (3),
depositing conformally, with respect to the inner contour of the trench (18), an electrically conductive layer (19) for the second capacitor electrode (12) within the trench (18),
conformally depositing an auxiliary layer (25), which serves as a spacer for the ferroelectric dielectric (13), within the trench (18) onto the electrically conductive layer (19) for the second capacitor electrode (12),
conformally depositing an electrically conductive layer (26) for the first capacitor electrode (11) within the trench (18) onto the auxiliary layer (25),
partially removing the auxiliary layer (25) and thereby uncovering a hollow layer (25a) between the two electrically conductive layers (19, 26) for the first and second capacitor electrodes,
depositing the ferroelectric dielectric (13) into the uncovered hollow layer (25a) between the two electrically conductive layers (19, 26) for the first and second capacitor electrodes.

14. Method for fabricating a semiconductor memory device according to Claim 13,
**characterized in that**
the step of depositing the dielectric layer having the ferroelectric dielectric (13) is carried out by means of spinning on.

15. Method for fabricating a semiconductor memory device according to Claim 13 or 14,
**characterized by**:
etching-back of the electrically conductive layer (19) - deposited conformally with respect to the inner contour of the trench (18) - for the second capacitor electrode (12) at least to an extent such that a part (23) of the upper edge region within the trench (18) and the part (24) - deposited in a planar manner outside the trench - of the electrically conductive layer (19) for the second capacitor electrode are removed.

16. Method for fabricating a semiconductor memory device according to one of Claims 13 to 15,
**characterized by**:
whole-area deposition of an electrically conductive layer (32) for the common conductor layer (10) onto the first capacitor electrode (11), and
whole-area deposition of a passivation layer (33) onto the common conductor layer (10).

17. Method for fabricating a semiconductor memory device according to one of Claims 13 to 16,
**characterized in that**
before the step of conformally depositing the auxiliary layer (25) serving as a spacer for the ferroelectric dielectric (13), the trench (18) is at least partially filled with an intermediate layer (22) made of an electrically insulating material.

18. Method for fabricating a semiconductor memory device according to Claim 17,
**characterized in that**
the intermediate layer (22) fabricated from an electrically insulating material (20) has a buffer layer for a wet-chemical etching and the step of at least partially filling the trench (18) with the intermediate layer (22) is followed by an etching-back of the buffer layer.

19. Method according to one of Claims 13 to 18,
**characterized in that**
the layers (19, 26) for the first or second capacitor electrode (11, 12) or for both capacitor electrodes (11, 12) are formed as a multilayer.

20. Method according to Claim 19,
**characterized in that**
the multilayer for the first or second capacitor electrode (11, 12) has the layer sequence titanium/titanium nitride/platinum.

21. Method according to one of Claims 13 to 20,
**characterized in that**
the intermediate layer (22), which is arranged between the bottom region of the second capacitor electrode (12) and the bottom section of the first capacitor electrode (11) which is formed in a cup-shaped manner within the second capacitor electrode (12), is fabricated from a flow glass material.

22. Method according to one of Claims 13 to 21,
**characterized in that**
the auxiliary layer (25) serving as a spacer for the ferroelectric dielectric (13), constitutes a CVD oxide.

## Revendications

1. Dispositif de mémoire à semi-conducteur comportant une pluralité de cellules (1) de mémoire qui sont disposées sur un substrat semi-conducteur, dont chacune comporte un transistor (3) de sélection, qui est disposé dans un plan (21) s'étendant sensiblement parallèlement à la surface d'un substrat semi-conducteur et qui comporte respectivement une borne (8) de grille ainsi qu'une première borne (5) d'électrode et une deuxième borne (6) d'électrode, et un condensateur (9) de mémorisation qui est associé au transistor (3) de sélection, qui peut être commandé au moyen de dernier et qui comporte un diélectrique (13) ainsi qu'une première électrode (11) de condensateur et une deuxième électrode (12) de condensateur, chaque borne (8) de grille du transistor (3) de sélection étant reliée à une ligne (7) de transmission de mots du dispositif de mémoire à semi-conducteur, chaque première borne (5) d'électrode du transistor (3) de sélection étant reliée à une ligne (4) de transmission de bits et chaque première électrode (11) de condensateur du condensateur (9) de mémorisation étant reliée à une couche (10) conductrice commune en un matériau conducteur de l'électricité, le condensateur (9) de mémorisation associé au transistor (3) de sélection ayant une disposition en saillie par rapport au plan (21) de la surface du substrat et la première électrode (11) de condensateur du condensateur (9) de mémorisation étant réalisée à l'intérieur de la deuxième électrode (12) de condensateur,
**caractérisé en ce que** le diélectrique (13) du condensateur (9) de mémorisation est ferroélectrique et **en ce qu'**il est présent entre une région de fond de la deuxième électrode (12) de condensateur et une partie de fond de la première électrode (11) de condensateur, au lieu du diélectrique (13), une couche (20, 22, 25) intermédiaire en un autre matériau isolant électriquement.

2. Dispositif de mémoire à semi-conducteur suivant la revendication 1,
**caractérisé en ce que** la disposition du condensateur (9) de mémorisation en saillie par rapport au plan (21) de la surface du substrat est sensiblement cylindrosymétrique en ayant un axe médian de cylindre s'étendant au moins à peu près perpendiculairement au plan (21) de la surface du substrat.

3. Dispositif de mémoire à semi-conducteur suivant la revendication 1 ou 2,
**caractérisé en ce que** le condensateur (9) de mémoire comportant le diélectrique (13) ferroélectrique est monté à l'intérieur d'un sillon (18) allant jusqu'à la deuxième borne (6) d'électrode du transistor (3) de sélection.

4. Dispositif de mémoire à semi-conducteur suivant la revendication 3,
**caractérisé en ce que** la deuxième électrode (12) de condensateur du condensateur (9) de mémorisation réalisée à l'intérieur du sillon (18) a une forme réalisée en bécher conformément au contour intérieur du sillon (18), en ayant une section transversale réalisée à peu près en forme de U ou de V transversalement à l'étendue longitudinale du condensateur (9) de mémorisation.

5. Dispositif de mémoire à semi-conducteur suivant la revendication 4,
**caractérisé en ce que** la région de fond de la deuxième électrode (12) de condensateur réalisée en section transversale à peu près en forme de U ou de V est reliée électriquement à la deuxième borne (6) d'électrode du transistor (3) de sélection.

6. Dispositif de mémoire à semi-conducteur suivant l'une des revendications 3 à 5,
**caractérisé en ce que** la première électrode (11) de condensateur du condensateur (9) de mémorisation comporte une partie d'électrode réalisée à l'intérieur du sillon (18), s'étendant coaxialement à l'étendue longitudinale du sillon (18) et faisant face à la deuxième électrode (12) de condensateur, et **en ce que** le diélectrique (13) est monté au moins entre la partie d'électrode de la première électrode (12) de condensateur et la deuxième électrode (12) de condensateur.

7. Dispositif de mémoire à semi-conducteur suivant l'une des revendications 1 à 6,
**caractérisé en ce que** la première électrode (11) de condensateur du condensateur (9) de mémoire est réalisée en forme de bécher à l'intérieur de la deuxième électrode (12) de condensateur.

8. Dispositif de mémoire à semi-conducteur suivant l'une des revendications 3 à 7,
**caractérisé en ce que** le sillon (18) est formé entièrement à l'intérieur d'une couche de métallisation ou de couches de métallisation représentant les lignes (7) de transmission de mots ainsi que les lignes (4) de transmission de bits du dispositif de mémoire à semi-conducteur et est muni pour l'isolation électrique vis à vis de la couche de métallisation ou des couches de métallisation d'un revêtement électrique isolant.

9. Dispositif de mémoire à semi-conducteur suivant l'une des revendications précédentes,
**caractérisé en ce que** le diélectrique (13) ferroélectrique représente un gel ferroélectrique qui contient du titanate de plomb et de zirconium (PZT) ou un composé de tantalate de strontium (y-1).

10. Dispositif de mémoire à semi-conducteur suivant l'une des revendications précédentes,
**caractérisé en ce que** le matériau des couches (19, 26) pour la première électrode (11) ou la deuxième électrode (12) de condensateur ou pour les deux électrodes (11, 12) de condensateur comporte du titane ou du platine.

11. Dispositif de mémoire à semi-conducteur suivant l'une des revendications précédentes,
**caractérisé en ce que** les couches (19, 26) pour la première électrode (11) ou la deuxième électrode (12) de condensateur ou pour les deux électrodes (11, 12) de condensateur sont réalisées en multicouche.

12. Dispositif de mémoire à semi-conducteur suivant la revendication 11,
**caractérisé en ce que** la multicouche pour la première électrode (11) ou la deuxième électrode (12) de condensateur ou pour les deux électrodes (11, 12) de condensateur comporte la succession de couches titane/nitrure de titane/platine.

13. Procédé pour fabriquer un dispositif de mémoire à semi-conducteur comportant une pluralité de cellules (1) de mémoire qui sont disposées sur un substrat à semi-conducteur, dont chacune comporte un transistor (3) de sélection, qui est monté dans un plan (21) s'étendant sensiblement parallèlement à la surface du substrat semi-conducteur et qui comporte respectivement une borne (8) de grille ainsi qu'une première borne (5) et une deuxième borne (6) d'électrode, et un condensateur (9) de mémorisation qui est associé au transistor (3) de sélection, qui peut être commandé au moyen de dernier et qui comporte un diélectrique (13) ferroélectrique ainsi qu'une première électrode (11) et une deuxième électrode (12) de condensateur, chaque borne (8) de grille du transistor (3) de sélection étant reliée à une ligne (7) de transmission de mots du dispositif de mémoire à semi-conducteur, chaque première borne (5) d'électrode du transistor (3) de sélection étant reliée à une ligne (4) de transmission de bits et chaque première électrode (11) de condensateur du condensateur (9) de mémorisation étant reliée à une couche (10) conductrice commune en un matériau conducteur de l'électricité, et le condensateur (9) de mémorisation, associé au transistor (3) de sélection et comportant le diélectrique (13) ferroélectrique étant, après finition du transistor (3) de sélection ainsi que de ses couches de métallisation associées pour le raccordement des lignes (4) de transmission de mots et des lignes (7) de transmission de bits, produit en une disposition en saillie par rapport au plan (21) du transistor (3) de sélection s'étendant sensiblement parallèlement à la surface du substrat semi-conducteur,
**caractérisé par** les étapes suivantes après finition du transistor (3) de sélection :
on réalise par attaque chimique un sillon (18) allant au moins jusqu'à la deuxième borne (6) d'électrode du transistor (3) de sélection,
on dépose de manière conforme au contour intérieur du sillon (18) une couche (19) conductrice de l'électricité pour la deuxième électrode (12) de condensateur à l'intérieur du sillon (18),
on dépose de manière conforme une couche (25) auxiliaire, servant à garder de la place pour le diélectrique (13) ferroélectrique, à l'intérieur du sillon (18), sur la couche (19) conductrice de l'électricité pour la deuxième électrode (12) de condensateur,
on dépose de manière conforme une couche (26) conductrice de l'électricité pour la première électrode (11) de condensateur à l'intérieur du sillon (18), sur la couche (25) auxiliaire,
on enlève en partie la couche (25) auxiliaire et on dégage ainsi une couche (25a) creuse entre les deux couches (19, 26) conductrices de l'électricité pour la première et la deuxième électrode de condensateur,
on dépose le diélectrique (13) ferroélectrique dans la couche (25a) creuse dégagée entre les deux couches (19, 26) conductrices de l'électricité pour la première et la deuxième électrode de condensateur.

14. Procédé de fabrication d'un dispositif de mémoire à semi-conducteur suivant la revendication 13,
**caractérisé en ce que** l'on effectue l'étape du dépôt de la couche diélectrique comportant le diélectrique (13) ferroélectrique au moyen d'une centrifugation.

15. Procédé de fabrication d'un dispositif de mémoire à semi-conducteur suivant la revendication 13 ou 14,
**caractérisé par** :
on effectue une attaque chimique en retrait de la couche (19) conductrice de l'électricité, déposée de manière conforme au contour intérieur du sillon (18), pour la deuxième électrode (12) de condensateur au moins jusqu'à enlever une partie (23) de la région supérieure de bord à l'intérieur du sillon (18) et la partie (24), déposée de manière planaire, à l'extérieur du sillon, de la couche (19) conductrice de l'électricité pour la deuxième électrode de condensateur.

16. Procédé de fabrication d'un dispositif de mémoire à semi-conducteur suivant l'une des revendications 13 à 15,
**caractérisé par** :
on dépose sur toute la surface une couche (32) conductrice de l'électricité pour la couche (10) conductrice commune sur la première électrode (11) de condensateur, et
on dépose sur toute la surface une couche (33) de passivation sur la couche (10) conductrice commune.

17. Procédé de fabrication d'un dispositif de mémoire à semi-conducteur suivant l'une des revendications 13 à 16,
**caractérisé en ce que**, avant l'étape du dépôt conforme de la couche (25) auxiliaire servant à conserver de la place pour le diélectrique (13) ferroélectrique, on remplit au moins en partie le sillon (18) d'une couche (22) intermédiaire en un matériau isolant électriquement.

18. Procédé de fabrication d'un dispositif de mémoire à semi-conducteur suivant la revendication 17,
**caractérisé en ce que** la couche (22) intermédiaire produite en un matériau (20) isolant électriquement comporte une couche tampon pour une attaque chimique en voie humide et **en ce qu'**une attaque chimique en retrait de la couche tampon vient après l'étape du remplissage au moins partiel du sillon (18) par la couche (22) intermédiaire.

19. Procédé suivant l'une des revendications 13 à 18,
**caractérisé en ce que** les couches (19, 26) pour la première électrode (11) ou la deuxième électrode (12) de condensateur ou pour les deux électrodes (11, 12) de condensateur sont réalisées en multicouche.

20. Procédé suivant la revendication 19,
**caractérisé en ce que** la multicouche pour la première électrode (11) ou la deuxième électrode (12) de condensateur comporte la succession de couches titane/nitrure de titane/platine.

21. Procédé suivant l'une des revendications 13 à 20,
**caractérisé en ce que** la couche (22) intermédiaire disposée entre la région de fond de la deuxième électrode (12) de condensateur et la partie de fond de la première électrode (11) de condensateur réalisée en forme de bécher à l'intérieur de la deuxième électrode (12) de condensateur est produite en un matériau flow-glas.

22. Procédé suivant l'une des revendications 13 à 21,
**caractérisé en ce que** la couche (25) auxiliaire servant à conserver de la place pour le diélectrique ferroélectrique représente un oxyde CVD.
